# EUROPEAN PATENT APPLICATION

(11) **EP 2 189 552 A2**
(43) Date of publication of application: **26.05.2010**
(21) Application number: 09176612.1
(22) Date of filing: 20.11.2009
(51) Int. Cl.: C23C 28/00, C23C 28/04, A61F 2/00, C23C 16/40, C23C 16/02

(54) **Substrate with multilayer coatings**

(30) Priority: 24.11.2008 US 117468 P
(71) Applicant: DePuy Products, Inc., Warsaw, IN 46581 (US)
(72) Inventor: Langhorn, Jason B, Warsaw, IN 46582 (US)
(74) Representative: Belcher, Simon James

(57) **Abstract**

A metal substrate is provided with scratch-, wear- and corrosion-resistant coatings which comprise multiple thin layers of titanium nitride, or titanium carbonitride, or both titanium nitride and titanium carbonitride, and may also contain a layer of aluminum oxide. A preferred coating is provided by alternating layers of titanium nitride and titanium carbonitride. The coatings can inhibit the growth of microcracks that can otherwise result from surface cracks or scratches on coated substrates, and thereby provide improved wear characteristics, resist scratching, and prevent the penetration of corrosive fluids to the substrate material. The coatings are suitable for use in orthopaedic implants.

## Description

The present invention relates to, among other things, wear-, scratch-, and corrosion-resistant coatings for metal substrates, such as those used to prepare medical implants.

Once installed, metallic orthopaedic implants are vulnerable to deterioration caused by scratching, wear, or otherwise damaging or corrosive processes that can occur *in situ*. Damaged implants may exhibit diminished performance, and in some cases must be repaired or replaced, and the complex and often physically traumatic surgical procedures necessary for doing so can delay the patient's progress towards rehabilitation. Furthermore, longer-lasting orthopaedic implants are of increasing interest due to demographic trends such as the increased life expectancy of implant recipients and the need for orthopaedic intervention among younger subjects (for example, due to sports injury, excessive body weight leading to joint stress, or poor health maintenance).

Implants comprising metallic substrates, including such materials as steel, cobalt, titanium, and alloys thereof, are also vulnerable to damage or mechanically-assisted corrosion that can lead to loss of structural integrity, abrasive wear by dissociated fragments or particles on physiological structures and implant surfaces, and reduction of implant performance.

Traditional approaches for improving the scratch- and wear-resistance of metallic orthopaedic implants have included surface treatments such as ion implantation, creation of surface nitride or oxide layers, and coating techniques, for example as disclosed in US-A-2007/0078521. However, certain limitations such as inability to provide an optimal level of peak hardness, poor adherence of coatings to underlying substrates, and economic feasibility may abridge the utility of some of these traditional methods.

In one aspect, the present invention provides methods comprising the steps of providing a metal substrate and depositing upon the metal substrate a first layer that has a thickness less than about 3 µm and comprises titanium nitride, titanium carbonitride, or both titanium nitride and titanium carbonitride. Such methods further comprise depositing upon the first layer a second layer that has a thickness less than about 1 µm and comprises titanium nitride, titanium carbonitride, or both titanium nitride and titanium carbonitride, and depositing upon the second layer at least one subsequent layer that has a thickness less than about 1 µm and comprises titanium nitride, titanium carbonitride, or both titanium nitride and titanium carbonitride. Preferred methods of this type also comprise the step of depositing upon the at least one subsequent layer at least one layer that comprises aluminum oxide.

Preferably, the first layer comprises titanium nitride.

Preferably, the last of the at least one subsequent layers that is deposited comprises titanium carbonitride.

Preferably, at least one of the layers comprises titanium nitride and at least one adjacent layer comprises titanium carbonitride.

Preferably, the at least one subsequent layer comprises one or more repetitions of the first layer and the second layer.

Preferably, the first layer comprises one of titanium nitride, titanium carbonitride, and both titanium nitride and titanium carbonitride, the second layer comprises a different one of titanium nitride, titanium carbonitride, and both titanium nitride and titanium carbonitride.

In another aspect, the invention provides a body which comprises: metal substrate; a first layer having a thickness that is less than about 3 µm and comprising titanium nitride, titanium carbonitride, or both titanium nitride and titanium carbonitride deposited upon the metal substrate; a second layer having a thickness that is less than about 1 µm and comprising titanium nitride, titanium carbonitride, or both titanium nitride and titanium carbonitride deposited upon the first layer, wherein the second layer is a different one of titanium nitride, titanium carbonitride, or both titanium nitride and titanium carbonitride than the first layer, and, subsequent layers that comprise one or more repetitions of the first layer and the second layer, wherein each of the subsequent layers has a thickness that is less than about 1 µm. The body may further comprise at least one layer of aluminum oxide deposited upon the subsequent layers.

The body might be used as a component of an orthopaedic joint prosthesis, for example a component of a hip joint prosthesis, or a knee joint prosthesis, or a shoulder joint prosthesis.

Embodiments of the invention are described below by way of example with reference to the accompanying drawings, in which:
FIG. 1 shows a coating for a CoCrMo substrate in accordance with a known technique.
FIG. 2 shows a scratch-, wear-, and corrosion-resistant coating for a CoCrMo substrate in accordance with the present invention.
FIG. 3 depicts the results of potentiodynamic polarization testing of scratch-damaged coating structures produced in accordance with the present invention as compared to results obtained with respect to conventional coatings.
FIG. 4 shows transmission electron microscope (TEM) images of a conventional "dual layer" TiN/TiCN coating.
FIG. 5 shows transmission electron microscope (TEM) images of a multilayer coating that was prepared in accordance with the present invention.
FIG. 6 provides magnified images of surfaces that were respectively coated with inventive and conventional coatings and subjected to scratch testing in order to compare the mechanical performance of the respective coatings.
FIG. 7 provides magnified images from an SEM analysis of polished cross sections of (A) conventional and (B) inventive coatings through 40 N constant load scratches.

In this document, the singular forms "a," "an," and "the" include the plural reference, and reference to a particular numerical value includes at least that particular value, unless the context clearly indicates otherwise. Thus, for example, a reference to "a material" is a reference to one or more of such materials and equivalents thereof known to the skilled the skilled person. When values are expressed as approximations, for example by use of the word "about," it will be understood that the particular value forms another embodiment. For example, the phrase "about X" (where X is a numerical value) preferably refers to ±10% of the recited value, inclusive. For example, the phrase "about 8" preferably refers to a value of 7.2 to 8.8, inclusive; as another example, the phrase "about 8%" preferably refers to a value of 7.2% to 8.8%, inclusive. Where present, all ranges are inclusive and combinable. For example, when a range of "1 to 5" is recited, the recited range should be construed as including ranges "1 to 4", "1 to 3", "1 to 2", "1 to 2 and 4 to 5", "1 to 3 & 5", and the like. In addition, when a list of alternatives is positively provided, such listing can be interpreted to mean that any of the alternatives may be excluded, e.g., by a negative limitation in the claims. For example, when a range of "1 to 5" is recited, the recited range may be construed as including situations in which any of 1, 2, 3, 4, or 5 are negatively excluded; thus, a recitation of "1 to 5" may be construed as "1 and 3 to 5, but not 2", or simply "wherein 2 is not included."

According to the present invention, it has been found that deposition of multiple "thin" layers of titanium nitride, titanium carbonitride, or both titanium nitride and titanium carbonitride to metal substrate materials for use in orthopaedic implants results in enhanced scratch-, wear- and corrosion-resistance. It has been observed that titanium nitride can nucleate and grow on certain substrates (such as CoCrMo) with a columnar grain structure that is oriented perpendicular to the substrate interface, that the subsequent layer of titanium carbonitride will grow in like fashion, and that when an outer alumina layer is deposited on this structure scratching of the outer alumina layer can lead to propagation of cracks through the subsequent layers to the metal substrate. In certain instances, corrosive fluids from the implant environment may gain access to the metal substrate, giving rise to the possibility of localized corrosion of the implant body upon which the coating has been deposited.

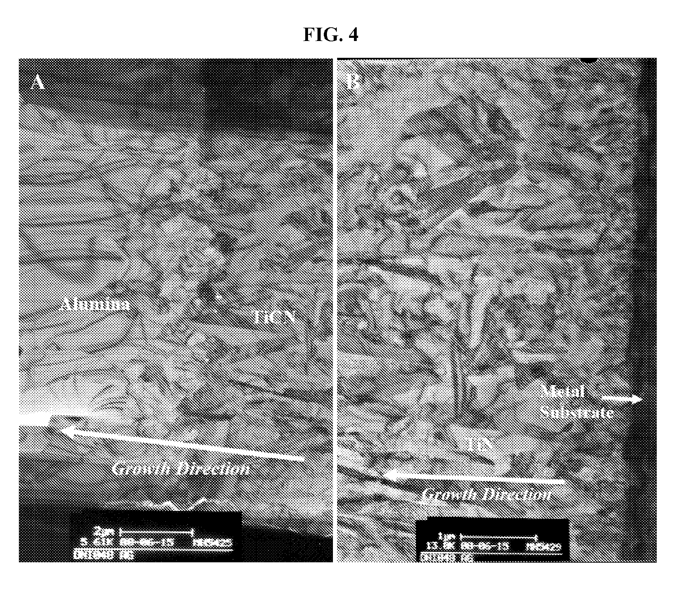

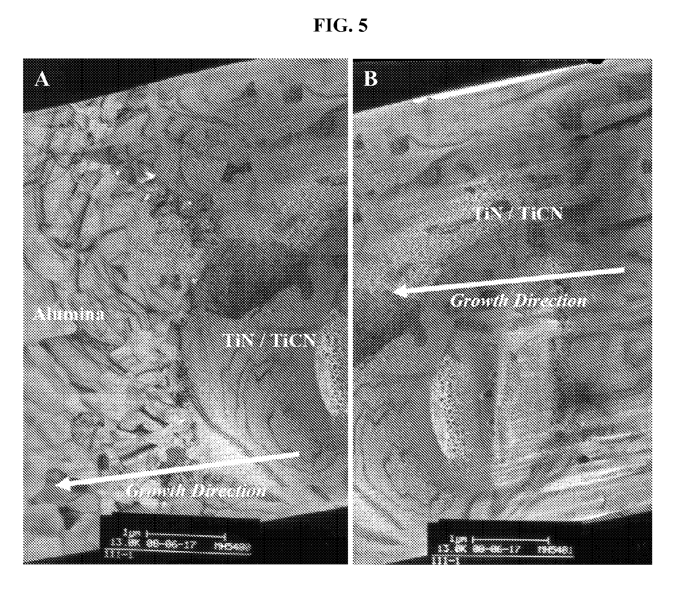

The present invention is directed to multiple "thin"-layer coatings that are resistant to wear and abrasion and inhibit the growth of microcracks that can otherwise result from abrasion of the surface of coated implants, and thereby prevent the penetration of corrosive fluids to the implant substrate material. Without wishing to be bound to any particular theory of operation, it is believed that the present multilayer coatings improve fracture toughness by reducing grain size and changing morphology within the coating film (see, e.g., Example 2 and FIGS. 4 and 5).

In accordance with the present invention, a first layer that has a thickness less than about 3 µm and comprises titanium nitride, titanium carbonitride, or both titanium nitride and titanium carbonitride is deposited upon a metal substrate. The metal substrate may be any metal, metal-containing, or partly metal material that is suitable for implantation within a living recipient. Suitability may be defined in terms of one or more of biocompatibility, mechanical strength, resistance to wear, machinability, natural resistance to corrosion, and the like. Metals are widely used as implants and may include stainless steels, precious metals, cobalt-chromium alloys (such as CoCrMo), titanium, aluminum, and various other alloys, e.g., of titanium and/or aluminum. The metal substrate is preferably in a final processed form and has been shaped, machined, moulded, surface treated, or otherwise rendered ready for implantation but for the improved wear- and abrasion-resistant and anti-corrosive coatings of the present invention. The metal substrate may represent the entirety of implant body or may be a portion of an implant, such as one or more surfaces or components of an implant. For example, the metal substrate onto which at least a portion of which the first layer, second layer, and subsequent layers are deposited may be a part of an implant that is subject to contact stress when implanted.

The deposition of the first layer upon the metal substrate preferably comprises directly contacting the metal substrate with the material of the first layer without intervening articles (e.g., intervening layers) or portions of articles. In such embodiments the first layer preferably directly contacts the metal substrate over the entire substrate, a surface of the substrate, or a portion of a surface of the substrate. Alternatively, one or more intervening layers, portions of layers, grains, patches, or other arrangements of a material or multiple materials other than that of the first layer may intervene between some portion of the substrate and some portion of the first layer. Thus, as used herein, the term "upon" when referring to the spatial relationship between the substrate and the first layer, or between any two layers as disclosed herein, means that the article that is said to be "upon" a different article is situated at least partially between the different article and, for example, the ambient environment, with or without intervening materials or layers between the article and the different article or some portion or portions thereof. For example, a layer of titanium carbonitride can be said to be upon a layer of titanium nitride as long as the titanium carbonitride layer is disposed at least partially between the titanium nitride layer and the ambient environment, regardless of whether there are intervening layers, portions of layers, or materials disposed between the titanium carbonitride layer and the titanium nitride layer, and/or layers, portions of layers, or materials between the titanium carbonitride layer and the ambient environment. The first layer preferably comprises a contiguous sheet or laminate of material, the entirety of which directly contacts the metal substrate.

The first layer may comprise titanium nitride, titanium carbonitride, or both titanium nitride and titanium carbonitride, titanium nitride being preferred. As used herein, "both titanium nitride and titanium carbonitride" means any mixture, combination, or other arrangement within or as part of a single layer such that at least some titanium nitride and at least some titanium carbonitride are both present. The thickness of the first layer may be less than about 3 µm (micrometers), less than about 2.5 µm, less than about 2 µm, less than about 1.5 µm, or less than about 1 µm. The first layer may be thicker than any subsequent layer, and the difference in thickness between the first layer and the thickest subsequent layer may be more than about 0.5 µm, more than about 0.75 µm, more than about 1 µm, more than about 1.25 µm, more than about 1.5 µm, or more than about 1.75 µm. As used herein, the "thickness" of a given layer refers to the average thickness of that layer over its entire area; accordingly, if the "thickness" of a layer is about 1 µm, there may be portions of that layer that are less than 1 µm thick, and/or portions of that layer that are thicker than 1 µm, but the average thickness over the entire area of the layer may be calculated as about 1 µm.

The deposition of any of the layers of the present invention may be performed in accordance with any acceptable technique that provides layers having the characteristics, e.g., thickness profile, as provided herein. Various suitable techniques will readily be appreciated by the skilled artisan, and may include physical vapour deposition, chemical vapour deposition, and thermal spraying deposition (for example, plasma spraying). Chemical vapour deposition (CVD) represents a preferred method for depositing any of the first, second, and/or subsequent layers, and enables the deposition of extremely thin (for example, micron or sub-micron) structures. The respective layers may each be deposited using a single technique, or different layers may be deposited using different techniques; for example, thicker layers may be deposited by a technique that is suitable for "thick" layer deposition, whereas thinner layers may be deposited by a technique that may achieve deposition of thinner layers.

The second layer preferably has a thickness that is less than about 1 µm and may comprise titanium nitride, titanium carbonitride, or both titanium nitride and titanium carbonitride. Where the first layer comprises one of titanium nitride, titanium carbonitride, or both titanium nitride and titanium carbonitride, the second layer preferably comprises a different one of titanium nitride, titanium carbonitride, or both titanium nitride and titanium carbonitride. For example, when the first layer comprises titanium nitride, the second layer preferably comprises titanium carbonitride, or comprises both titanium nitride and titanium carbonitride. For purposes of the present disclosure, a layer that comprises "both titanium nitride and titanium carbonitride" is considered "different" than a layer that comprises titanium nitride but no titanium carbonitride, and is considered "different" than a layer that comprises titanium carbonitride but no titanium nitride. In addition, a layer comprising "both titanium nitride and titanium carbonitride" that has a different quantity of either titanium nitride, of titanium carbonitride, or both, as compared with a second layer that comprises "both titanium nitride and titanium carbonitride" would be considered "different" than the second layer.

The second layer may have a thickness that is less than about 1 µm, less than about 0.75 µm, less than about 0.5 µm, less than about 0.3 µm, less than about 0.2 µm, or less than about 0.1 µm. The second layer preferably has a thickness that is less than that of the first layer.

Following the deposition of the second layer upon the first layer, at least one subsequent layer is deposited upon the second layer. In accordance with the present invention, at least one to about 100 subsequent layers may be deposited following the deposition of the second layer. In some embodiments, not more than about 30 to about 50, or not more than about 40 to 50, subsequent layers are deposited. The combined thickness of the first layer, the second layer, and the at least one subsequent layer may be about 3 µm to about 20 µm, or may be about 5 µm to about 10 µm.

The thickness of each of the subsequent layers may be less than about 1 µm, and the respective subsequent layers may each be of the same thickness or may be of varying thicknesses. A given subsequent layer may be less than about 0.75 µm, less than about 0.5 µm, less than about 0.3 µm, less than about 0.2 µm (e.g., about 0.1 µm), or less than about 0.1 µm. Each of the subsequent layers may have a thickness that is less than that of the first layer, the same as that of the second layer, more than that of the second layer, or less than that of the second layer.

The subsequent layers may comprise one or more repetitions of the first and second layers. As used herein, a layer that is a "repetition" of a different layer is generally of the same chemical composition as the different layer, of the same thickness as the different layer, or both. For example, if the first layer includes only titanium nitride and the second layer includes only titanium carbonitride, two subsequent layers that are repetitions of the first and second layers will include only titanium nitride and titanium carbonitride, respectively. The entirety of the complement of subsequent layers may comprise one or more repetitions of the first and second layers, or only some of the subsequent layers may comprise one or more repetitions of the first and second layers. In one embodiment, the second layer is different than the first layer, and all of the subsequent layers comprise repetitions of the first and second layers; the resulting structure will therefore comprise layers that alternate between the material of the first layer and the material of the second layer. In a preferred version of this embodiment, the first layer is titanium nitride, the second layer is titanium carbonitride, and the subsequent layers comprise alternating layers of titanium nitride and titanium carbonitride. Among the first layer, the second layer, and the at least one subsequent layer, it is preferred that at least one of the layers comprises titanium nitride and at least one adjacent layer comprises titanium carbonitride. The top or final layer, i.e., the last of the at least one subsequent layers, may comprise titanium carbonitride.

Following the deposition of the subsequent layer(s), at least one layer that comprises aluminum oxide may be deposited upon the last/top/uppermost subsequent layer, that is upon the last layer comprising titanium nitride, titanium carbonitride, or both titanium nitride and titanium carbonitride. For purposes of the present disclosure, unless otherwise specified, "aluminum oxide" and "alumina" both refer to any crystalline form of Al₂O₃. One or more particular crystalline forms of aluminum oxide may be used in the at least one layer comprising aluminum oxide. For example, the aluminum oxide layer may comprise alpha aluminum oxide, kappa aluminum oxide, or one or more of the other crystalline forms of aluminum oxide, with which those skilled in the art are familiar.

A layer of aluminum oxide may have a thickness of about 2 µm to about 15 µm, for example, about 3 µm to about 15 µm, about 4 µm to about 15 µm, or about 5 µm to about 15 µm. An aluminum oxide layer may be thicker than any of the first, second, or subsequent layers. The thickness of an aluminum oxide layer may be dictated by any of a number of considerations readily understood by the skilled person, such as production cost, implant type, environment of use, layer adhesion, inherent layer durability, and the like. The aluminum oxide layer is preferably the outermost layer that is deposited in accordance with the present methods, such that no layers of titanium nitride, titanium carbonitride, or titanium nitride and titanium carbonitride are disposed between the aluminum oxide and, for example, the ambient environment. In other embodiments, the outermost layer may be a layer of titanium nitride, titanium carbonitride, or both titanium nitride and titanium carbonitride, and in such embodiments, the outermost layer may have a thickness that is greater than about 1 µm, greater than about 2 µm, or greater than about 3 µm. An aluminum oxide layer may be at least partially in direct contact with the ambient environment, or the aluminum oxide layer may at least partially be coated with a material that is disposed between the aluminum oxide and the ambient environment. For example, a protective coating layer, a friction-enhancing or reducing layer, a sterilization layer, a tissue integration promoting layer, or another material may be applied to at least part of the outer surface of an aluminum oxide layer.

An aluminum oxide layer may be deposited by any suitable deposition technique, such as any of the techniques describe above with respect to the deposition of the first, second, and at least one subsequent layers. For example, chemical vapour deposition may be used to deposit an aluminum oxide layer in accordance with the present invention.

The present methods may include depositing a bonding layer upon the at least one subsequent layer prior to depositing the at least one layer that comprises aluminum oxide. In other words, a bonding layer may be deposited upon the last/outermost of the at least one subsequent layers, immediately spatially prior to a layer of aluminum oxide. Such bonding layers are also known as alumina bonding layers, oxide bonding layers, or kappa or alpha nucleation layers and have been previously described for use in increasing the bonding strength between an aluminum oxide layer and an adjacent material and/or to promote the formation of the desired aluminum oxide crystalline phase. Examples of bonding layers between aluminum oxide and an adjacent material that may be used are disclosed in US-4463062, US-6156383, US-7094447, US-A-2005/0191408, and in Zhi-Jie Liu, et al, "Investigations of the bonding layer in commercial CVD coated cemented carbide inserts", Surface & Coatings Technology 198 (2005) 161- 164. The bonding layer may comprise one or more of an oxide, an oxycarbide, an oxynitride, and an oxycarbonitride of a metal from Group IVa, Va, or VIa of the periodic table of the elements. For example, the bonding layer may comprise one or more of a titanium oxide, a titanium oxycarbide, a titanium oxynitride, and a titanium oxycarbonitride. In some embodiments the bonding layer may be a mixture of materials, such as a mixture of oxides, for example, a mixture of titanium oxides.

Available techniques for depositing a bonding layer will be appreciated by those skilled in the art, such as any of the techniques describe above with respect to the deposition of the first, second, and at least one subsequent layers. For example, chemical vapour deposition may be used to deposit a bonding layer in accordance with the present invention. Bonding layers may have a thickness that is less than 2 µm, and may have a thickness less than 1 µm, less than 500 nm, less than 250 nm, less than 100 nm, less than 50 nm, less than 30 nm, less than 20 nm, or less than 10 nm. Various companies (for example, lonbond, Madison Heights, MI) provide the service of applying bonding layers and can be contacted for this purpose.

In another aspect there are provided bodies comprising a metal substrate; a first layer having a thickness that is less than about 3 µm and comprising titanium nitride, titanium carbonitride, or both titanium nitride and titanium carbonitride deposited upon the metal substrate; a second layer having a thickness that is less than about 1 µm and comprising titanium nitride, titanium carbonitride, or both titanium nitride and titanium carbonitride deposited upon the first layer, wherein the second layer is a different one of titanium nitride, titanium carbonitride, or both titanium nitride and titanium carbonitride than said first layer, and, subsequent layers that comprise one or more repetitions of the first layer and the second layer, wherein each of the subsequent layers has a thickness that is less than about 1 µm. The bodies provided by the invention may be used in preparing orthopaedic implants.

Also disclosed are implants comprising a metal substrate; a first layer having a thickness that is less than about 3 µm and comprising titanium nitride, titanium carbonitride, or both titanium nitride and titanium carbonitride deposited upon the metal substrate; a second layer having a thickness that is less than about 1 µm and comprising titanium nitride, titanium carbonitride, or both titanium nitride and titanium carbonitride deposited upon the first layer, wherein the second layer is a different one of titanium nitride, titanium carbonitride, or both titanium nitride and titanium carbonitride than said first layer, subsequent layers that comprise one or more repetitions of the first layer and the second layer, in which each of the subsequent layers has a thickness that is less than about 1 µm; and, at least one layer of aluminum oxide deposited upon the subsequent layers. As used herein, the term "implant" may refer to a construct that may be installed within a subject, or a component or portion of a construct that may be installed within a subject.

The metal substrate in the presently disclosed bodies and implants may be any metal, metal-containing, or partly metal material that is suitable for implantation within a living recipient. Suitability may be defined in terms of one or more of biocompatibility, mechanical strength, resistance to wear, machinability, natural resistance to corrosion, and the like. Metals are widely used as implants and may include stainless steels, precious metals, cobalt-chromium alloys (such as CoCrMo), titanium, aluminum, and various other alloys, for example of titanium and/or aluminum. The metal substrate is preferably in a final processed form and has been shaped, machined, moulded, surface treated, or otherwise rendered ready for implantation but for the abrasion and corrosion-resistant coatings of the present invention. The metal substrate may represent the entirety of the body or implant or may be a portion thereof, such as one or more surfaces or components of a body or implant. For example, the metal substrate on to which at least a portion of which the first layer, second layer, and subsequent layers are deposited may be a part of an implant that is subject to contact stress when implanted.

The spatial relationship between the first layer and the metal substrate preferably comprises direct contact between the metal substrate with the material of the first layer without intervening articles (e.g., intervening layers) or portions of articles. In such embodiments the first layer preferably directly contiguously contacts the metal substrate over the entire substrate, a surface of the substrate, or a portion of a surface of the substrate. Alternatively, one or more intervening layers, portions of layers, grains, patches, or other arrangements of a material or multiple materials other than that of the first layer may intervene between some portion of the substrate and some portion of the first layer. Thus, as provided above, the term "upon" when referring to the spatial relationship between the substrate and the first layer, or between any two layers as disclosed herein, means that the article that is said to be "upon" a different article is situated at least partially between the different article and the ambient environment, with or without intervening materials or layers between the article and the different article or some portion or portions thereof. For example, a layer of titanium carbonitride can be said to be upon a layer of titanium nitride as long as the titanium carbonitride layer is disposed at least partially between the titanium nitride layer and the ambient environment, regardless of whether there are intervening layers, portions of layers, or materials disposed between the titanium carbonitride layer and the titanium nitride layer, and/or layers, portions of layers, or materials between the titanium carbonitride layer and the ambient environment. The first layer preferably comprises a contiguous sheet or laminate of material, the entirety of which directly contacts the metal substrate.

The first layer of the coating of the body (or implant) may comprise titanium nitride, titanium carbonitride, or both titanium nitride and titanium carbonitride, titanium nitride being preferred. The thickness of the first layer may be less than about 3 µm (micrometers), less than about 2.5 µm, less than about 2 µm, less than about 1.5 µm (e.g., about 1 µm), or less than about 1 µm. The first layer may be thicker than any subsequent layer, and the difference in thickness between the first layer and the thickest subsequent layer may be more than about 0.5 µm, more than about 0.75 µm, more than about 1 µm, more than about 1.25 µm, more than about 1.5 µm, or more than about 1.75 µm.

The deposition of any of the layers of the present invention may be performed in accordance with any acceptable technique that provides layers having the characteristics, e.g., thickness profile, as provided herein. Various suitable techniques will readily be appreciated by the skilled artisan, and may include physical vapour deposition, chemical vapour deposition, and thermal spraying deposition (for example, plasma spraying). Chemical vapour deposition (CVD) represents a preferred method for depositing any of the first, second, and/or subsequent layers, and enables the deposition of extremely thin (e.g., micron or sub-micron) structures. The respective layers may each be deposited using a single technique, or different layers may be deposited using different techniques; for example, thicker layers may be deposited by a technique that is suitable for "thick" layer deposition, whereas thinner layers may be deposited by a technique that may achieve deposition of thinner layers.

The second layer has a thickness that is less than about 1 µm and may comprise titanium nitride, titanium carbonitride, or both titanium nitride and titanium carbonitride. Where the first layer comprises one of titanium nitride, titanium carbonitride, or both titanium nitride and titanium carbonitride, the second layer may comprise a different one of titanium nitride, titanium carbonitride, or both titanium nitride and titanium carbonitride. For example, when the first layer comprises titanium nitride, the second layer may preferably comprise titanium carbonitride, or may comprise both titanium nitride and titanium carbonitride.

The second layer may have a thickness that is less than about 1 µm, less than about 0.75 µm, less than about 0.5 µm, less than about 0.3 µm, less than about 0.2 µm (for example, about 1 µm), or less than about 0.1 µm. The second layer preferably has a thickness that is less than that of the first layer.

The present bodies and implants further comprise at least one subsequent layer that is deposited upon the second layer. In accordance with the present invention, at least one to about 50 subsequent layers may be included, and are deposited following the deposition of the second layer. In one embodiment, no more than about 30 to about 40 subsequent layers are included. The combined thickness of the first layer, the second layer, and the at least one subsequent layer may be about 3 µm to about 20 µm, or may be about 5 µm to about 10 µm.

The thickness of each of the subsequent layers may be less than about 1 µm, and the respective subsequent layers may each be of the same thickness or may be of varying thicknesses. A given subsequent layer may be less than about 0.75 µm, less than about 0.5 µm, less than about 0.3 µm, less than about 0.2 µm (e.g., about 0.1 µm), or less than about 0.1 µm. Each of the subsequent layers may have a thickness that is less than that of the first layer, the same as that of the second layer, more than that of the second layer, or less than that of the second layer.

The subsequent layers may comprise one or more repetitions of the first and second layers. As specified previously, a layer that is a "repetition" of a different layer is generally of the same chemical composition as the different layer, of the same thickness as the different layer, or both. For example, if the first layer is titanium nitride and the second layer is titanium carbonitride, two subsequent layers that are repetitions of the first and second layers will comprise titanium nitride and titanium nitride, respectively. The entirety of the complement of subsequent layers may comprise one or more repetitions of the first and second layers, or only some of the subsequent layers may comprise one or more repetitions of the first and second layers. In one embodiment, the second layer is different than the first layer, and all of the subsequent layers comprise repetitions of the first and second layers; the resulting structure will therefore comprise layers that alternate between the material of the first layer and the material of the second layer. In a preferred version of this embodiment, the first layer is titanium nitride, the second layer is titanium carbonitride, and the subsequent layers comprise alternating layers of titanium nitride and titanium carbonitride. Among the first layer, the second layer, and the at least one subsequent layer, it is preferred that at least one of the layers comprises titanium nitride and at least one adjacent layer comprises titanium carbonitride. The top or final layer, i.e., the last of the at least one subsequent layers, may comprise titanium carbonitride.

The present implants further comprise at least one layer that comprises aluminum oxide, such at least one aluminum oxide layer being deposited upon the last/top/uppermost subsequent layer, i.e., upon the last layer comprising titanium nitride, titanium carbonitride, or both titanium nitride and titanium carbonitride. One or more particular crystalline forms of aluminum oxide may be used in the at least one layer comprising aluminum oxide. For example, the aluminum oxide layer may comprise alpha aluminum oxide, kappa aluminum oxide, or one or more of the other crystalline forms of aluminum oxide, with which those skilled in the art are familiar.

A layer of aluminum oxide may have a thickness of about 2 µm to about 15 µm, for example, about 3 µm to about 15 µm, about 4 µm to about 15 µm, or about 5 µm to about 15 µm. An aluminum oxide layer may be thicker than any of the first, second, or subsequent layers. The thickness of an aluminum oxide layer may be determined by any of a number of considerations readily understood among those skilled in the art, such as production cost, implant type, environment of use, layer adhesion, inherent layer durability, and the like. The aluminum oxide layer is preferably the outermost layer that is deposited in accordance with the present methods, such that no layers of titanium nitride, titanium carbonitride, or titanium nitride and titanium carbonitride are disposed between the aluminum oxide and the ambient environment. An aluminum oxide layer may be at least partially in direct contact with the ambient environment, or the aluminum oxide layer may at least partially be coated with a material that is disposed between the aluminum oxide and the ambient environment. For example, a protective coating layer, a friction-enhancing layer, a sterilization layer, or another material may be applied to at least part of the outer surface of an aluminum oxide layer.

An aluminum oxide layer may be deposited by any suitable deposition technique, such as any of the techniques describe above with respect to the deposition of the first, second, and at least one subsequent layers. For example, chemical vapour deposition may be used to deposit an aluminum oxide layer in accordance with the present invention.

The present implants may include a bonding layer upon the at least one subsequent layer. The bonding layer is deposited prior to the deposition of the at least one layer that comprises aluminum oxide. In other words, a bonding layer may be deposited upon the last / outermost of the at least one subsequent layers, immediately spatially prior to a layer of aluminum oxide. Pertinent background information regarding bonding layers is provided supra with respect to the present methods. The bonding layer of the present implants may comprise one or more of an oxide, an oxycarbide, an oxynitride, and an oxycarbonitride of a metal from Group IVa, Va, or VIa of the periodic table of the elements. For example, the bonding layer may comprise one or more of a titanium oxide, a titanium oxycarbide, a titanium oxynitride, and a titanium oxycarbonitride. In some embodiments the bonding layer may be a mixture of materials, such as a mixture of oxides, for example, a mixture of titanium oxides.

Available techniques for depositing a bonding layer will be appreciated by those skilled in the art, such as any of the techniques describe above with respect to the deposition of the first, second, and at least one subsequent layers. For example, chemical vapour deposition may be used to deposit a bonding layer in accordance with the present invention. Bonding layers may have a thickness that is less than 2 µm, and may have a thickness less than 1 µm, less than 500 nm, less than 250 nm, less than 100 nm, less than 50 nm, less than 30 nm, less than 20 nm, or less than 10 nm.

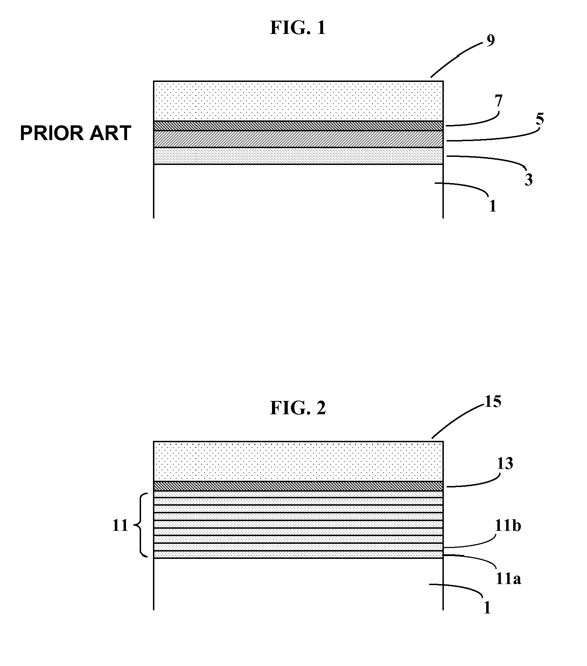

FIG. 1 depicts a coating for a CoCrMo substrate 1 in accordance with known techniques. Traditional coatings included, for example, a relatively thick (∼2 µm) layer 3 of titanium nitride deposited upon the substrate 1, a similarly thick layer 5 of titanium carbonitride upon the titanium nitride layer 3, a top layer 7 of aluminum oxide, and a bonding layer 5 disposed between the titanium carbonitride layer 5 and the aluminum oxide layer 7.

FIG. 2 provides a schematic of a coating arrangement for a CoCrMo substrate in accordance with the present invention. Numerous (i.e., at least three total) layers 11 comprising titanium nitride, titanium carbonitride, or both titanium nitride and titanium carbonitride are deposited upon the substrate. Each of the layers 11 preferably have a thickness that is less than 2 µm. The first 11a of such layers 11 that is deposited upon the substrate 1 is preferably titanium nitride, and the second 11b of such layers 11 is preferably titanium carbonitride. A top layer 15 of aluminum oxide may be bonded to the top / last /outermost of layers 11 by an intervening bonding layer 13.

### EXAMPLE 1 - Corrosion Testing

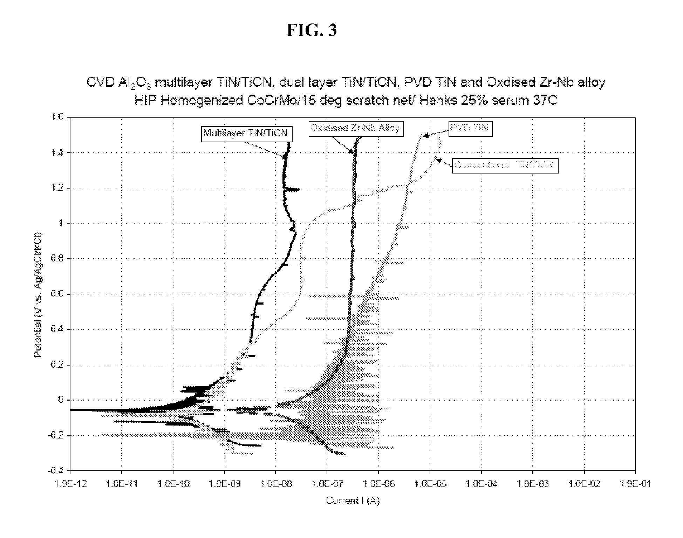

Potentiodynamic polarization testing demonstrated that aggressively scratch-damaged coatings in accordance with the present invention display much-improved behaviour as compared with conventional "dual layer" TiN/TiCN coatings (with an alumina overcoat), TiN-only coatings applied by physical vapour deposition (PVD), and oxidized Zr-Nb, respectively. The inventive coatings herein described show substantially lower anodic currents through 1.5 V and no evidence of substrate dissolution or pitting on post-test sectioned samples. FIG. 3 depicts the results of potentiodynamic polarization testing of aggressively scratch-damaged coating structures produced in accordance with the present invention as compared to results obtained with respect to conventional coatings.

### EXAMPLE 2 - TEM Imaging of Coatings

FIGS. 4A and 4B provide photographs acquired by transmission electron microscope (TEM) imaging of a conventional, "dual layer" coating (a single layer of TiN and a single layer of TiCN, with an Al₂O₃ overcoat) on a metal substrate. In the conventional structure, the TiN layer and the TiCN layer both have a thickness of about 2.5 µm, and the Al₂O₃ overcoat has a thickness of about 5 µm. It was observed that the dual layer structures consist of relatively large, high aspect ratio grains of TiN and TiCN (up to 2 to 3 µm in the growth direction).

FIGS. 5A and 5B provide TEM images of inventive multilayer TiN/TiCN coatings on a metal substrate. The coatings depicted in FIGS. 5A and 5B comprise a first layer of TiN having a thickness of 1 µm, a second layer of TiCN (having a thickness of about 0.1 µm) on top of the first TiN layer, and, on top of the second layer, alternating subsequent layers of TiN and TiCN, each subsequent layer having a thickness of about 0.1 µm. The total thickness of the multilayer structure is about 5 µm. The structure also includes an A1203 overcoat having a thickness of about 5 µm (visible in FIG. 5A). In clear contrast with the conventional structure, the images of the inventive multilayer coating revealed that the grains of TiN and TiCN were so small that they could not be distinguished as discrete elements within the TiN/TiCN multilayer structure. Accordingly, observations of improved microstructure and grain morphology were made, with larger acicular grains growing perpendicular to the substrate in the conventional dual layer structure being replaced by very fine, randomly-oriented grains in the present multilayer coating structure. Such features provide physical evidence that the multilayer coatings of the present invention improve fracture toughness and resistance to the growth of microcracks, at least by reducing grain size and changing morphology within the coating film. Without intending to be bound by any particular theory of operation, it appeared as if the smaller, randomly oriented grain structure in the present coatings provided improved mechanical performance by removing anisotropic nature of the TiN and TiCN in the coating.

### EXAMPLE 3 - Scratch Testing of Coatings

To compare the mechanical performance of conventional coatings and the present multilayer coatings under conditions resulting in surface damage, scratches of length 10 mm were formed along the surface of coated samples using a 200 µm diameter indenter tip under a constant load of 40 N. Micrographs were obtained at 50× magnification, and the results were evaluated.

The multilayer coating in accordance with the present invention included a first layer of TiN having a thickness of 1 µm, a second layer of TiCN having a thickness of about 0.1 µm on top of the first TiN layer, and, on top of the second layer, alternating subsequent layers of TiN and TiCN, each subsequent layer having a thickness of about 0.1 µm. The total thickness of the multilayer structure was about 5 µm, and the structure also included an Al₂O₃ overcoat having a thickness of about 5 µm.

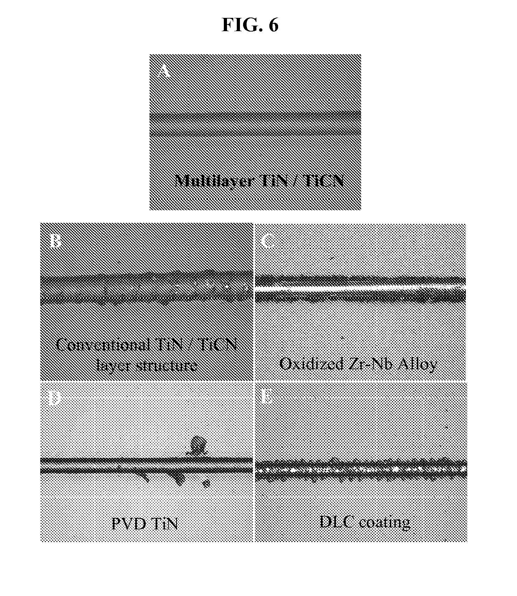

As depicted in FIGS. 6A to E, the results of the test revealed superior mechanical performance of the inventive multilayer TiN/TiCN/alumina CVD coating (FIG. 6A) as compared with each of the conventional coatings.

With respect to the "dual layer" structure (a single 3 µm thick layer of TiN, a single 3 µm thick layer of TiCN, and a 5 µm thick alumina overlayer; FIG. 6B), it was observed that cracks and alumina spalls (Lc2-type cracking per ASTM C1624-051 specification) occurred at regular intervals along the scratch length, whereas there were no macroscopic cracks observed in the inventive structure (FIG. 6A).

Scratching of the oxidized Zr-Nb alloy (5 µm oxide layer) at such relatively high loads (Zr is relatively soft) resulted in exposure of the base substrate material within the scratch trough along the entire length of the test damage (FIG. 6C; substrate material visible as a white line at the centre of the scratch).

The images of the monolayer TiN coating (thickness 10 µm, deposited by arc evaporation PVD) on a Ti-6Al-4V substrate show that large chips of the coating material were removed along the scratch line, exposing the substrate material (FIG. 6D).

The diamond-like carbon (DLC) coating (thickness 6 µm, deposited by PVD on F75 CoCrMo substrate) underwent considerable chipping under 40 N applied loads (FIG. 6E).

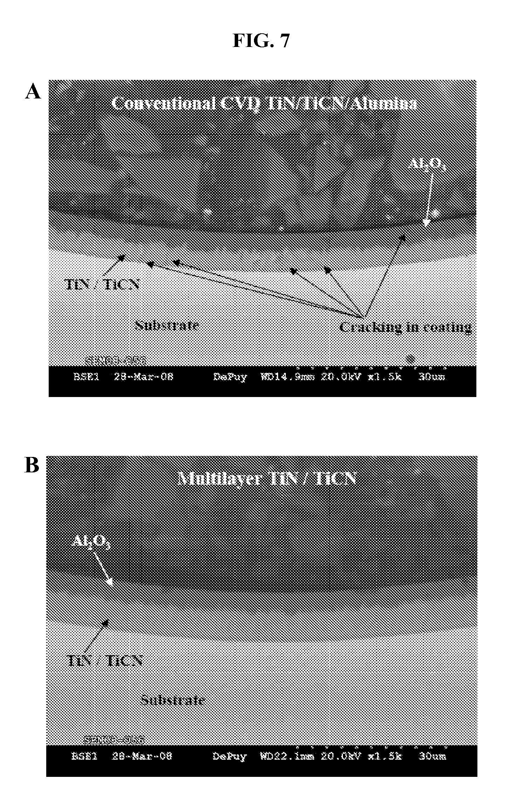

FIG. 7 provides magnified images from a scanning electron microscope (SEM) analysis of polished cross sections of conventional and inventive coatings through 40 N constant load scratches. It is apparent that the coating of the present invention (FIG. 7B) is far less susceptible to microcracking within the TiN/TiCN layers under the alumina overlayer than the "conventional CVD" structure, in which cracks and fissures are observed within the TiN and TiCN monolayers (FIG. 7A).

These results demonstrate that multilayer coatings of the present invention minimize scratch-induced damage and are more effective in preventing the generation of microcracks as compared with conventional coatings.

### EXAMPLE 4 - Thickness Testing of Multilayer Coatings

Multilayer coatings in accordance with the present invention were formed using chemical vapour deposition. Target conditions for a high temperature chemical vapour deposition (HT-CVD) multilayer coating were set as follows:

| Layer | Target (µm) |
|---|---|
| TiN | 2.5 |
| TiN/TiCN multilayer | 3.75 |
| α Alumina | 5 |

Within the TiN / TiCN multilayer construct, each deposited layer was targeted to be 0.109 µm. Thus, in order to form the desired 3.75 µm TiN/TiCN multilayer, 38 individual layers (19 TiN and 19 TiCN) were formed.

Testing of the chemical vapour deposition (CVD) process was been undertaken on nominal, large and small sized implants to investigate variance in implant size and relative coating area in CVD reactor lots, referred to as component of variance (COV) study.

Experiments were undertaken to exercise CVD process limits. High limit CVD run was undertaken with large sized (maximum surface area) femoral implants, and low CVD settings with small (minimum surface area) implants.

High limit process variation on large sized femoral knee implants was completed using high limit settings (e.g., temperature, gas flow, pressure, time, and the like) on the both the medical implant cleaning lines and CVD reactor equipment.

Low limit process variation on large sized femoral knee implants was completed using low limit settings (e.g., temperature, gas flow, pressure, time, and the like) on the both the medical implant cleaning lines and CVD reactor equipment.

Coupons added to each CVD validation cycle, for destructive analyses (cross sectioning, scratch testing, and the like) have shown that very good correlation between thickness measurements made on implants and coupons can be made by cross sectioning.

Experimental results were as follows:
*COV experiments*: All implants and validation coupons were within specifications with respect to TiN, multilayer TiN/TiCN and alumina thickness (measured by XRF and cross sectioning). All implants and coupons were within specifications for scratch adhesion and microhardness.
*High limit process variation run*: All implants and validation coupons were measured to be within specifications with respect to TiN and multilayer TiN/TiCN thickness (measured by XRF and cross sectioning). Implants averaged within the target band for alumina thickness (measured by XRF and cross sectioning). All implants and coupons were within specifications for scratch adhesion and microhardness. In addition, there was a very good correlation between thickness measurements made on implants and coupons that had been made by cross sectioning.
*Low limit process variation run*: Implants averaged within the target band for TiN/multilayer thickness (measured by XRF and cross sectioning). All implants were within specifications for alumina thickness (measured by XRF and cross sectioning). All implants and coupons were within specifications for scratch adhesion and microhardness. There was also a very good correlation between thickness measurements made on implants and coupons that had been made by cross sectioning.

## Claims

1. A body comprising:
a metal substrate;
a first layer having a thickness that is less than about 3 µm and comprising titanium nitride, titanium carbonitride, or both titanium nitride and titanium carbonitride deposited upon the metal substrate;
a second layer having a thickness that is less than about 1 µm and comprising titanium nitride, titanium carbonitride, or both titanium nitride and titanium carbonitride deposited upon the first layer, in which second layer is a different one of titanium nitride, titanium carbonitride, or both titanium nitride and titanium carbonitride than the first layer, and
at least one subsequent layer that comprises one or more repetitions of the first layer and the second layer, in which the or each subsequent layer has a thickness that is less than about 1 µm.

2. A body as claimed in claim 1, in which the substrate comprises metal or a metal alloy, and preferably comprises CoCrMo.

3. A body as claimed in claim 1, in which the first layer comprises titanium nitride.

4. A body as claimed in claim 1, in which the last of the at least one subsequent layers that is deposited prior to the depositing of the at least one layer of aluminum oxide comprises titanium carbonitride.

5. A body as claimed in claim 1, in which the first layer, the second layer, and the subsequent layers have a combined thickness that is from about 3 µm to about 20 µtm, preferably from about 5 µm to about 10 µm.

6. A body as claimed in claim 1, in which the first layer has a thickness that is less than about 2 µm, for example about 1 µm.

7. A body as claimed in claim 1, in which each of the second layer and subsequent layers has a thickness that is less than about 0.5 µm, preferably less than about 0.2 µm.

8. A method comprising the steps of:
providing a metal substrate;
depositing upon the metal substrate a first layer that has a thickness less than about 3 µm and comprises titanium nitride, titanium carbonitride, or both titanium nitride and titanium carbonitride;
depositing upon the first layer a second layer that has a thickness less than about 1 µm and comprises titanium nitride, titanium carbonitride, or both titanium nitride and titanium carbonitride; and,
depositing upon the second layer at least one subsequent layer that has a thickness less than about 1 µm and comprises titanium nitride, titanium carbonitride, or both titanium nitride and titanium carbonitride.

9. A method as claimed in claim 8, in which the number of subsequent layers is not more than about 100, preferably not more than about 50.

10. A method as claimed in claim 8, in which the first layer has a thickness that is less than about 2 µm, for example about 1 µm.

11. A method as claimed in claim 8, in which each of the second layer and the at least one subsequent layer has a thickness that is less than about 0.5 µm, preferably less than about 0.2 µm.

12. A method as claimed in claim 8, in which the first layer, the second layer, and the at least one subsequent layer have a combined thickness that is from about 3 µm to about 20 µm, preferably from about 5 µm to about 10 µm.

13. A method as claimed in claim 8, in which at least one of the layers is deposited by chemical vapour deposition.

14. A method as claimed in claim 8, in which all of the layers are applied by chemical vapour deposition.
